# EUROPEAN PATENT APPLICATION

(11) **EP 4 518 011 A1**
(43) Date of publication of application: **05.03.2025**
(21) Application number: 23795954.9
(22) Date of filing: 17.03.2023
(51) Int. Cl.: H01M 50/569, H01M 50/209, H01M 50/296

(54) **VOLTAGE DETECTION DEVICE AND BATTERY MODULE**

(30) Priority: 28.04.2022 JP 2022074766
(71) Applicant: AESC Japan Ltd., Kanagawa, 2520012 (JP)
(72) Inventor: OKAZUMI, Ryoma, Zama-shi, Kanagawa 252-0012 (JP); IZAWA, Takami, Zama-shi, Kanagawa 252-0012 (JP)
(74) Representative: Mathys & Squire
(86) International application number: PCT/JP2023/010562
(87) International publication number: WO 2023/210207

(57) **Abstract**

A front voltage detection device (30) includes a holder (310), a plurality of voltage detection lines (320), and a socket (330). The plurality of voltage detection lines (320) is electrically connected to a plurality of battery cells (100). The plurality of voltage detection lines (320) is held on the holder (310). The socket (330) is electrically connected to the plurality of voltage detection lines (320). The socket (330) is provided on the holder (310).

## Description

### TECHNICAL FIELD

The present invention relates to a voltage detection device and a battery module.

### BACKGROUND ART

For example, as described in Patent Document 1, a battery module includes a plurality of battery cells, a housing, a wire harness, and a connector. The housing accommodates the plurality of battery cells. The connector is electrically connected to the plurality of battery cells via the wire harness. In a voltage detection device described in Patent Document 1, the connector is attached to the housing.

### RELATED DOCUMENT

### PATENT DOCUMENT

Patent Document 1: Japanese Patent Application Publication (Translation of PCT Application) No. 2020-517051

### SUMMARY OF INVENTION

### TECHNICAL PROBLEM

For example, as described in Patent Document 1, when a connector is attached to a housing, the connector is attached to an accommodation body after a plurality of battery cells and a wire harness are accommodated in the housing. In this case, however, for example, the necessity of an extra length of a wire harness for drawing out the wire harness to an outside of a housing may cause reducing workability for assembling a battery module.

One example of an object of the present invention is to improve workability for assembling a battery module. Another object of the present invention will be clarified from description of the present specification.

### SOLUTION TO PROBLEM

One aspect of the present invention is as follows.
[1] A voltage detection device including:
   a holder;
   a plurality of voltage detection lines electrically connected to a plurality of battery cells and held on the holder; and
   a connector electrically connected to the plurality of voltage detection lines and provided on the holder.
[2] The voltage detection device according to [1], in which the connector is provided with a terminal hole through which at least a portion of an external terminal is inserted.
[3] The voltage detection device according to [1] or [2], in which there is a gap through which at least a portion of an external connector to be connected to the connector is inserted.
[4] The voltage detection device according to any one of [1] to [3], further including attaching structure attaching the holder and the connector to each other.
[5] A voltage detection device including:
   a holder;
   a plurality of voltage detection lines electrically connected to a plurality of battery cells and held on the holder; and
   a socket electrically connected to the plurality of voltage detection lines, in which
   at least a portion of the socket is embedded in a recess portion provided in the holder.
[6] The voltage detection device according to [5], in which
   there is a gap between the socket and the recess portion.
[7] The voltage detection device according to [5] or [6], in which
   the plurality of battery cells is stacked in a predetermined first direction,
   the holder is located on a side of a second direction orthogonal to the first direction with respect to the plurality of battery cells, and
   the recess portion is provided on a surface of the holder on a side of a third direction orthogonal to the first direction and the second direction.
[8] A battery module including:
   the plurality of battery cells; and
   the voltage detection device according to any one of [1] to [7].

### ADVANTAGEOUS EFFECTS OF INVENTION

Workability for assembling a battery module can be improved according to the above aspect of the present invention.

### BRIEF DESCRIPTION OF THE DRAWINGS

[Fig. 1] A front perspective view of a battery module according to an embodiment.
[Fig. 2] A diagram with an accommodation body removed from Fig. 1.
[Fig. 3] An enlarged perspective view of one portion of a front voltage detection device according to the embodiment.
[Fig. 4] A diagram with two sockets and a plug removed from Fig. 3.
[Fig. 5] A rear perspective view of the socket according to the embodiment.
[Fig. 6] An enlarged perspective view of a front portion of a front voltage detection device according to a variant 1.
[Fig. 7] An enlarged perspective view of a front portion of a front voltage detection device according to a variant 2.
[Fig. 8] An enlarged perspective view of one portion of a front voltage detection device according to a variant 3.

### DESCRIPTION OF EMBODIMENTS

Hereinafter, an embodiment according to the present invention is described by using the drawings. In all drawings, a similar constituent element is indicated by a similar reference sign, and description thereof is omitted as necessary.

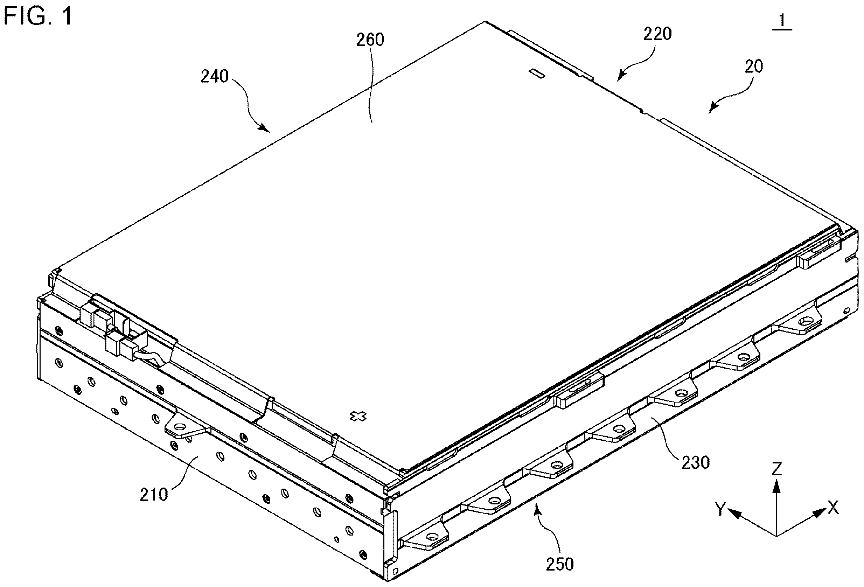

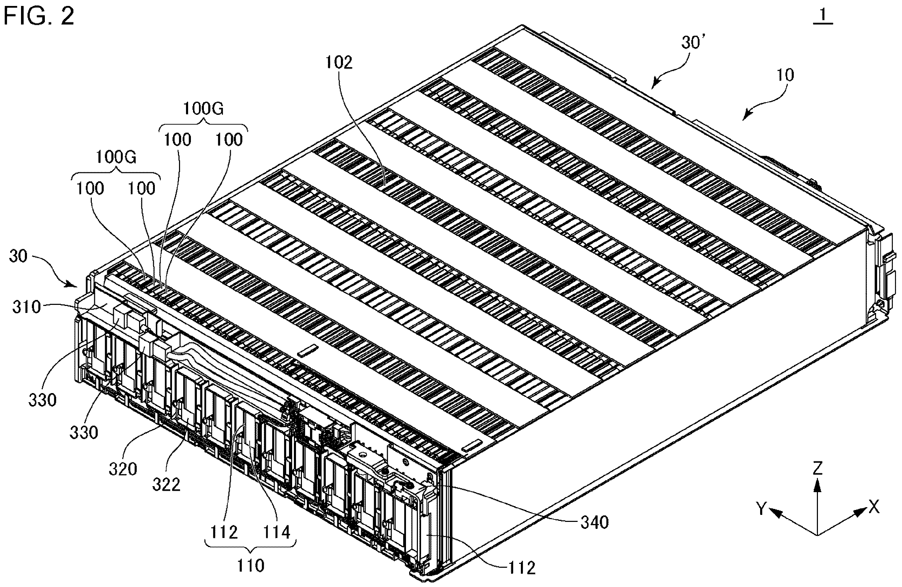

Fig. 1 is a front perspective view of a battery module 1 according to an embodiment. Fig. 2 is a diagram with accommodation body 20 removed from Fig. 1.

In each drawing, an arrow indicating an X direction, a Y direction, and a Z direction is illustrated for explanation. The X direction indicates a front-rear direction of the battery module 1. Hereinafter, unless otherwise specifically noted, a tip end side of the arrow indicating the X direction is a rear side of the battery module 1. Hereinafter, unless otherwise specifically noted, a proximal end side of the arrow indicating the X direction is a front side of the battery module 1. The Y direction is orthogonal to the X direction. The Y direction indicates a left-right direction of the battery module 1. Hereinafter, unless otherwise specifically noted, a tip end side of the arrow indicating the Y direction is a left side of the battery module 1.
Hereinafter, unless otherwise specifically noted, a proximal end side of the arrow indicating the Y direction is a right side of the battery module 1. The Z direction is orthogonal to both of the X direction and the Y direction. The Z direction indicates an up-down direction of the battery module 1. Hereinafter, unless otherwise specifically noted, a tip end side of the arrow indicating the Z direction is an upper side of the battery module 1. Hereinafter, unless otherwise specifically noted, a proximal end side of the arrow indicating the Z direction is a lower side of the battery module 1. The relations between the X direction, the Y direction, and the Z direction, and the front-rear direction, the left-right direction, and the up-down direction of the battery module 1, however, is not limited to the above example. These relations differ according to an actual arrangement of the battery module 1.

The battery module 1 includes a cell stack 10, the accommodation body 20, a front voltage detection device 30, and a rear voltage detection device 30'. The cell stack 10 includes a plurality of cell groups 100G. Each cell group 100G includes a plurality of battery cells 100. The accommodation body 20 includes a front cover 210, a rear cover 220, a right cover 230, a left cover 240, a lower cover 250, and an upper cover 260. The front voltage detection device 30 includes a holder 310, a plurality of voltage detection lines 320, two sockets 330, and a terminal 340. A plurality of voltage detection tip end portions 322 are provided at ends of the plurality of voltage detection lines 320 on a side of a tab group 110 described later.

The plurality of battery cells 100 are stacked in the Y direction. Each battery cell 100 has a substantially rectangular shape when viewed from the Y direction. A long direction of each battery cell 100 is substantially in parallel to the X direction. A short direction of each battery cell 100 is substantially in parallel to the Z direction. A thickness direction of each battery cell 100 is substantially in parallel to the Y direction. The structure of each battery cell 100, however, is not limited to this example.

Each battery cell 100 includes an unillustrated battery element, an exterior member 102, a positive electrode tab 112, and a negative electrode tab 114. The exterior member 102 seals the battery element and unillustrated electrolytic liquid. The battery element includes a plurality of unillustrated positive electrodes and a plurality of unillustrated negative electrodes alternately stacked in the Y direction and an unillustrated separator located between the positive electrode and the negative electrode adjacent to each other in the Y direction. The positive electrode tab 112 and the negative electrode tab 114 are drawn out from opposite sides the exterior member 102 in the X direction. The positive electrode tab 112 is electrically connected to the above plurality of positive electrodes. The positive electrode tab 112 is composed of, for example, aluminum. The negative electrode tab 114 is electrically connected to the above plurality of negative electrodes. The negative electrode tab 114 is composed of, for example, copper.

Each cell group 100G includes two battery cells 100 connected in parallel to each other. The positive electrode tabs 112 drawn out from two battery cells 100 included in each cell group 100G face the same side in the X direction. The negative electrode tabs 114 drawn out from two battery cells 100 included in each cell group 100G face the same side in the X direction. The positive electrode tabs 112 and the negative electrode tabs 114 drawn out from one of the cell groups 100G adjacent to each other in the Y direction and the positive electrode tabs 112 and the negative electrode tabs 114 drawn from the other of the cell groups 100G adjacent to each other in the Y direction face opposite sides in the X direction.

The plurality of cell groups 100G are connected in series. The cell groups 100G adjacent to each other in the Y direction include a tab group 110 located on the front side or the rear side of the cell groups 100G. The tab group 110 includes the two positive electrode tabs 112 drawn from one of the cell groups 100G adjacent to each other in the Y direction and the two negative electrode tabs 114 drawn out from the other of the cell groups 100G adjacent to each other in the Y direction. In the tab group 110, the two positive electrode tabs 112 and the two negative electrode tabs 114 are joined to one another, for example, by laser welding. A plurality of tab groups 110 located on the front side of the cell stack 10 and a plurality of tab groups 110 located on the rear side of the cell stack 10 are alternately placed in the Y direction. In an example illustrated in Fig. 2, therefore, the cell group 100G located on a leftmost side and the cell group 100G located second from the left side, for example, include the tab group 110 located on the front side of these cell groups 100G. The cell group 100G located second from the left side and the cell group 100G located third from the left side include the tab group 110 located on the rear side of these cell groups 100G.

The structure of the cell stack 10 is not limited to the above example. For example, each cell group 100G may include three or more battery cells 100. A plurality of single battery cells 100 may be connected in series.

The accommodation body 20 includes the cell stack 10, the front voltage detection device 30, and the rear voltage detection device 30'. The front cover 210 covers the front side of the cell stack 10 and the front voltage detection device 30. The rear cover 220 covers the rear side of the cell stack 10 and the rear voltage detection device 30'. The right cover 230 covers a right side of the cell stack 10. The left cover 240 covers a left side of the cell stack 10. The lower cover 250 covers a lower side of the cell stack 10. The upper cover 260 covers an upper side of the cell stack 10.

The holder 310 is provided on the front side of the cell stack 10. The holder 310 is formed of, for example, resin. The holder 310 integrally holds the plurality of voltage detection lines 320, the plurality of voltage detection tip end portions 322, and the two sockets 330. Therefore, positioning the holder 310 with respect to the cell stack 10 enables to position the plurality of voltage detection lines 320 and the plurality of voltage detection tip end portions 322. For example, the holder 310 is positioned with respect to the cell stack 10 by attaching the holder 310 to the accommodation body 20. When the holder 310 is positioned, each of the plurality of voltage detection tip end portions 322 is located on the front side of each of the plurality of tab groups 110 located on the front side of the cell stack 10.

The plurality of voltage detection lines 320 are, for example, a wire harness. Each of the plurality of voltage detection lines 320 electrically connects each of the plurality of tab groups 110 and the socket 330 to each other. Specifically, one end of each of the plurality of voltage detection lines 320 is electrically connected to each of the plurality of tab groups 110 located on the front side of the cell stack 10 via each of the plurality of voltage detection tip end potions 322. Each voltage detection tip end portion 322 is, for example, a conductive plate such as a metal plate. Each voltage detection tip end portion 322 is joined to a front surface of each tab group 110, for example, by laser welding. The other end of each of the plurality of voltage detection lines 320 is electrically connected to the socket 330.

The terminal 340 is electrically connected to the positive electrode tab 112 drawn out to the front side from the battery cell 100 disposed on the rightmost side. The cell stack 10 is electrically connectable to external equipment via the terminal 340.

Similarly to the front voltage detection device 30, the rear voltage detection device 30' includes an unillustrated holder, a plurality of unillustrated voltage detection lines, an unillustrated connector, and an unillustrated terminal. The terminal of the rear voltage detection device 30' is electrically connected to the negative electrode tab 114 drawn out to the rear side from the battery cell 100 disposed on the leftmost side.

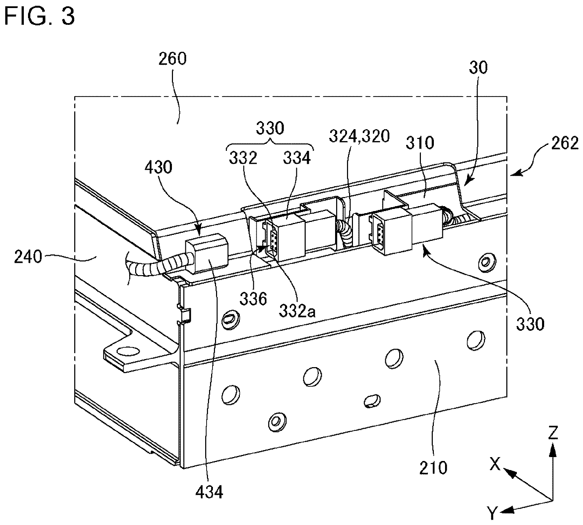

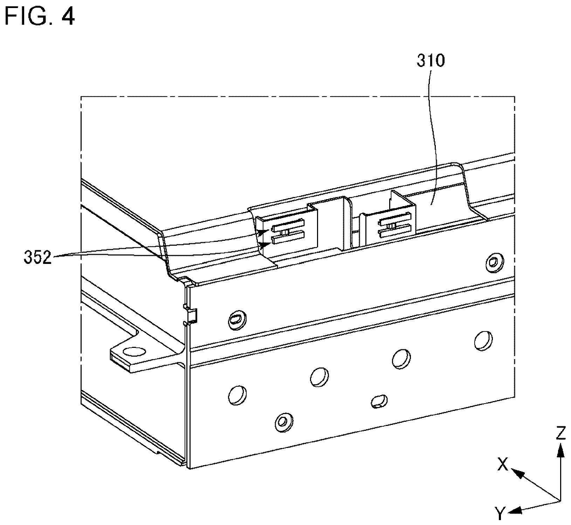

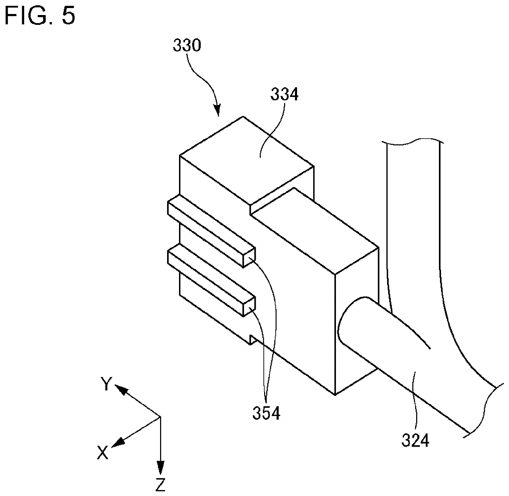

Fig. 3 is an enlarged perspective view of one portion of the front voltage detection device 30 according to the embodiment. Fig. 4 is a diagram with the two sockets 330 and a plug 430 removed from Fig. 3. Fig. 5 is a rear perspective view of the socket 330 according to the embodiment.

The two sockets 330 and the plug 430 are described with reference to Fig. 3.

As illustrated in Fig. 3, a step 262 is provided on a front end of the upper cover 260. The step 262 makes the front end portion of the upper cover 260 located at the position lower in the Z direction than the rear portion of the front end portion of the upper cover 260. The two sockets 330 illustrated in Fig. 3 are disposed in a space formed by the step 262. This can improve volumetric efficiency of the battery module 1.

The plug 430 illustrated in Fig. 3 is connectable to the left socket 330 illustrated in Fig. 3. The plug 430 includes a plurality of unillustrated terminals and a plug cover 434. The plurality of terminals of the plug 430 protrude toward the right side. The plug cover 434 surrounds the plurality of terminals of the plug 430 when viewed from a right side of the plug 430. Accordingly, foreign matter such as a finger of a worker or dust can be less likely to contact with the plurality of terminals of the plug 430 as compared with when the plurality of terminals of the plug 430 are not surrounded by the plug cover 434.

The left socket 330 illustrated in Fig. 3 includes a body 332 and a socket cover 334. Some voltage detection lines 320 of the plurality of voltage detection lines 320 are electrically connected to the left socket 330 illustrated in Fig. 3. In an example illustrated in Fig. 3, the some the voltage detection lines 320 are connected to the socket 330 through a tube 324 attached to the socket 330.

A plurality of terminal holes 332a is formed in the body 332. A terminal is embedded inside the plurality of terminal holes 332a. In the socket 330 according to the embodiment, therefore, the terminal can be less likely to contact with foreign matter such as a finger of a worker or dust as compared with when the terminal of the socket 330 protrudes to outside. Each of the above plurality of terminals of the plug 430 is inserted through each of the plurality of terminal holes 332a in the Y direction. The socket 330 and the plug 430 are electrically connected to each other by inserting the plurality of terminals of the plug 430 through each of the plurality of terminal holes 332a in the Y direction.

The socket cover 334 surrounds at least a portion of the body 332 with a gap 336 between them. The socket 330 and the plug 430 are connected to each other by inserting at least a portion of the plug cover 434 through the gap 336 in the Y direction. Accordingly, the mechanical connection of the socket 330 and the plug 430 can be strengthened as compared with when the gap 336 and the plug cover 434 are not provided. The gap 336 and the plug cover 434, however, may not be provided. Also in this case, the socket 330 and the plug 430 can be mechanically connected to each other by inserting each of the above plurality of terminals of the plug 430 through each of the plurality of terminal holes 332a in the Y direction.

The right socket 330 illustrated in Fig. 3 includes a configuration similar to that of the left socket 330 illustrated in Fig. 3. When the two sockets 330 are provided, some of the voltage detection lines 320 can be electrically connected to one of the sockets 330 and the other of the voltage detection lines 320 can be electrically connected to the other socket 330. For this reason, the number of terminal holes 332 of each socket 330 can be reduced as compared with when all the plurality of voltage detection lines 320 are electrically connected to a single socket 330. For example, when at least some of the terminal holes 332a of each socket 330 are arranged in the Z direction, a width of each socket 330 in the Z direction can be reduced. This can prevent an upper surface of each socket 330 from protruding upward from an upper surface of the upper cover 260. However, the front voltage detection device 30 may include only one socket 330 or may include three or more sockets 330.

The right socket 330 illustrated in Fig. 3 is disposed on the front side with respect to the left socket 330 illustrated in Fig. 3. That is, the two sockets 330 illustrated in Fig. 3 are displaced from each other in the X direction. Accordingly, a space for passing the plurality of voltage detection lines 320 connected to the right socket 330 illustrated in Fig. 3 can be secured on the rear side of the left socket 330 illustrated in Fig. 3. Accordingly, a space in the Y direction for arranging the two sockets 330 illustrated in Fig. 3 can be reduced as compared with when the two sockets 330 illustrated in Fig. 3 are aligned in the X direction. The layout of the sockets 330, however, is not limited to this example. For example, the two sockets 330 illustrated in Fig. 3 may be aligned in the X direction.

A method of attaching the left socket 330 illustrated in Fig. 3 to the holder 310 is described by using Figs. 4 and 5.

As illustrated in Fig. 4, a pair of locking grooves 352 are formed on a front surface of the holder 310. The pair of locking grooves 352 extend substantially in parallel to each other in the Y direction. As illustrated in Fig. 5, a pair of locking portions 354 are provided on a rear surface of the socket cover 334. The pair of locking portions 354 extend substantially in parallel to the Y direction. The pair of locking portions 354 are insertable through the pair of locking grooves 352 from a left side of the pair of locking grooves 352 in the Y direction. The socket 330 is attached to the holder 310 by inserting the pair of locking portions 354 through the pair of locking grooves 352 from a left side of the pair of locking grooves 352 in the Y direction. That is, the pair of locking grooves 352 and the pair of locking portions 354 are attaching structure attaching the holder 310 and the left socket 330 illustrated in Fig. 3 to each other. The attaching structure, however, is not limited to an example of the pair of locking grooves 352 and the pair of locking portions 354. The right socket 330 illustrated in Fig. 3 is also attached to the holder 310 by attaching structure similar to the attaching structure of the left socket 330 illustrated in Fig. 3.

As described above, in an example illustrated in Figs. 4 and 5, the above attaching structure, that is, the pair of locking grooves 352 and the pair of locking portions 354 are located on a rear surface side of the socket 330. Accordingly, the attaching structure does not interfere with the plug cover 434 when the plug cover 434 is inserted through the gap 336 in the Y direction. Accordingly, the plug cover 434 does not need provided with a cutout for avoiding interference of the attaching structure. Accordingly, lowering of strength of the plug cover 434 due to the cutout can be suppressed. However, the plug cover 434 may be provided with the cutout according to needs.

In the embodiment, the socket 330 is provided on the holder 310. Accordingly, the cell stack 10 and the front voltage detection device 30 can be accommodated in the accommodation body 20 after the front voltage detection device 30 is attached to the cell stack 10. For example, when the socket 330 is provided on the accommodation body 20, the socket 330 is provided on the accommodation body 20 after the cell stack 10 is accommodated in the accommodation body 20. This case, however, requires an extra length of the plurality of voltage detection lines 320 for drawing out the plurality of voltage detection lines 320 to the outside of the accommodation body 20. The embodiment, on the other hand, does not need consideration of the extra length of the plurality of voltage detection lines 320. In the embodiment, the workability for assembling the battery module 1 can be therefore improved as compared with when the socket 330 is provided on the accommodation body 20.

In the embodiment, the socket 330 serves as a connector provided on the front voltage detection device 30, and the plug 430 serves as an external connector of the front voltage detection device 30. However, a connector provided on the front voltage detection device 30 may serve as a plug, and an external connector of the front voltage detection device 30 may serve as a socket. This example also does not require consideration of the above extra length of the plurality of voltage detection lines 320 in assembling the battery module 1. In the embodiment, the workability for assembling the battery module 1 can be therefore improved as compared with when the above plug is provided on the accommodation body 20.

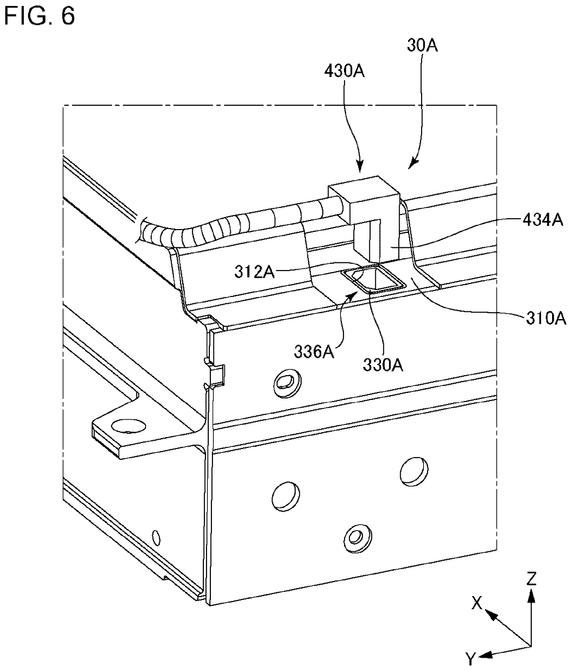

Fig. 6 is an enlarged perspective view of a front portion of a front voltage detection device 30A according to a variant 1. The front voltage detection device 30A according to the variant 1 is similar to the front voltage detection device 30 according to the embodiment except for the following point.

At least a portion of a socket 330A is embedded in a recess portion 312A formed on an upper surface of a holder 310A. A gap 336A is provided between an outer lateral surface of the socket 330A and an inner lateral surface of the recess portion 312A. A plug 430A is connectable to the socket 330A from an upper side of the socket 330A. The socket 330A and the plug 430A are mechanically connected to each other by inserting a plug cover 434A through the gap 336A in the Z direction. Also in the variant 1, the mechanical connection of the socket 330A and the plug 430A can be therefore strengthened similarly to the embodiment.

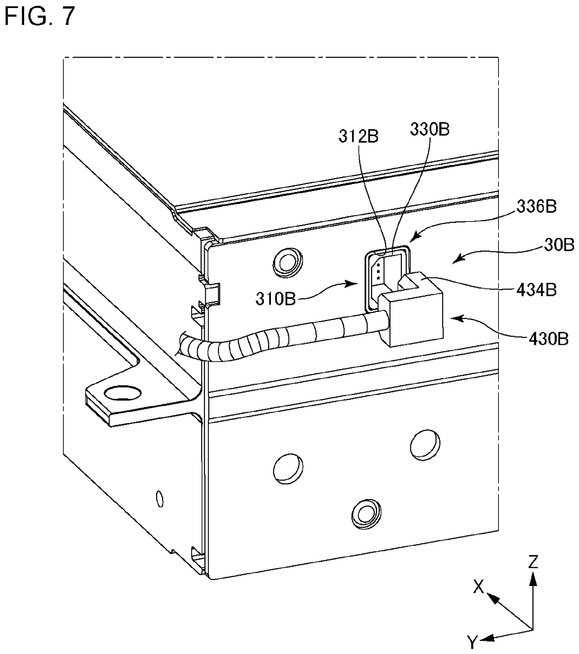

Fig. 7 is an enlarged perspective view of a front portion of a front voltage detection device 30B according to a variant 2. The front voltage detection device 30B according to the variant 2 is similar to the front voltage detection device 30 according to the embodiment except for the following point.

At least a portion of a socket 330B is embedded in a recess portion 312B formed on a front surface of a holder 310B. A gap 336B is provided between an outer lateral surface of the socket 330B and an inner lateral surface of the recess portion 312B. A plug 430B is connectable to the socket 330B from the front side of the socket 330B. The socket 330B and the plug 430B are mechanically connected to each other by inserting a plug cover 434B through the gap 336B in the X direction. Also in the variant 2, the mechanical connection of the socket 330B and the plug 430B can be therefore strengthened similarly to the embodiment.

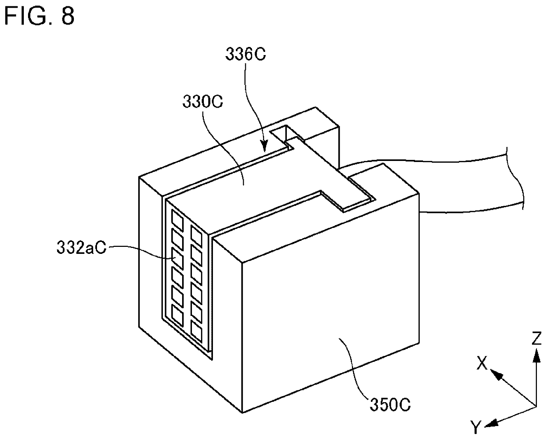

Fig. 8 is an enlarged perspective view of one portion of a front voltage detection device 30C according to a variant 3. The front voltage detection device 30C according to the variant 3 is similar to the front voltage detection device 30 according to the embodiment except for the following point.

The front voltage detection device 30C according to the variant 3 includes a socket holder 350C. The socket holder 350C is attached to an unillustrated holder 310. The socket holder 350C holds a socket 330C. In an example illustrated in Fig. 8, a plurality of terminal holes 332aC is provided on a left lateral surface of the socket 330C. The socket holder 350C holds the socket 330C with a gap 336C formed between the socket 330C and a portion of the socket holder 350C surrounding the socket 330C. The socket 330C and an unillustrated plug 430 are mechanically connected to each other by inserting an unillustrated plug cover 434 through the gap 336C in the Y direction similarly to the embodiment.

In the foregoing, an embodiment according to the present invention has been described with reference to the drawings; however, these are examples of the present invention, and various configurations other than the above can also be adopted.

This application claims priority based on Japanese patent application No. 2022-074766, filed on April 28, 2022, the disclosure of which is incorporated herein in its entirety by reference.

### REFERENCE SIGNS LIST

1 Battery module, 10 Cell stack, 20 Accommodation body, 30, 30A, 30B, 30C Front voltage detection device, 100 Battery cell, 100G Cell group, 102 Exterior member, 110 Tab group, 112 Positive electrode tab, 114 Negative electrode tab, 210 Front cover, 220 Rear cover, 230 Right cover, 240 Left cover, 250 Lower cover, 260 Upper cover, 262 Step, 310, 310A, 310B Holder, 312A, 312B Recess portion, 320 Voltage detection line, 322 Voltage detection tip end portion, 324 Tube, 330, 330A, 330B, 330C Socket, 332 Body, 332a, 332aC Terminal hole, 334 Socket cover, 336, 336A, 336B, 336C Gap, 340 Terminal, 350C Socket holder, 352 Locking groove, 354 Locking portion, 430, 430A, 430B Plug, 434, 434A, 434B Plug cover

## Claims

1. A voltage detection device comprising:
a holder;
a plurality of voltage detection lines electrically connected to a plurality of battery cells and held on the holder; and
a connector electrically connected to the plurality of voltage detection lines and provided on the holder.

2. The voltage detection device according to claim 1, wherein the connector is provided with a terminal hole through which at least a portion of an external terminal is inserted.

3. The voltage detection device according to claim 1 or 2, wherein there is a gap through which at least a portion of an external connector to be connected to the connector is inserted.

4. The voltage detection device according to any one of claims 1 to 3, further comprising attaching structure attaching the holder and the connector to each other.

5. A voltage detection device comprising:
a holder;
a plurality of voltage detection lines electrically connected to a plurality of battery cells and held on the holder; and
a socket electrically connected to the plurality of voltage detection lines, wherein
at least a portion of the socket is embedded in a recess portion provided in the holder.

6. The voltage detection device according to claim 5, wherein there is a gap between the socket and the recess portion.

7. The voltage detection device according to claim 5 or 6, wherein
the plurality of battery cells is stacked in a predetermined first direction,
the holder is located on a side of a second direction orthogonal to the first direction with respect to the plurality of battery cells, and
the recess portion is provided on a surface of the holder on a side of a third direction orthogonal to the first direction and the second direction.

8. A battery module comprising:
the plurality of battery cells; and
the voltage detection device according to any one of claims 1 to 7.
